# NEUE EUROPÄISCHE PATENTSCHRIFT

(11) **EP 0 742 926 B2**
(45) Veröffentlichungstag und Bekanntmachung des Hinweises auf die Entscheidung über den Einspruch: **27.06.2007**
(45) Hinweis auf die Patenterteilung: 08.07.1998
(21) Anmeldenummer: 95909671.0
(22) Anmeldetag: 03.02.1995
(51) Int. Cl.: G06K 19/077, G06K 19/02, B32B 29/00, G06K 19/07, B42D 15/10

(54) **DATENTRÄGER MIT EINEM ELEKTRONISCHEN MODUL UND VERFAHREN ZUR HERSTELLUNG DESSELBEN**
DATA CARRIER WITH AN ELECTRONIC MODULE AND PROCESS FOR PRODUCING THE SAME
SUPPORT DE DONNEES A MODULE ELECTRONIQUE ET SON PROCEDE DE FABRICATION

(30) Priorität: 04.02.1994 DE 4403513
(43) Veröffentlichungstag der Anmeldung: 20.11.1996
(73) Patentinhaber: Giesecke & Devrient GmbH, 81677 München (DE)
(72) Erfinder: HAGHIRI, Yahya, D-80797 München (DE); OJSTER, Albert, D-81373 München (DE); BARAK, Renée-Lucia, D-82008 Unterhaching (DE)
(74) Vertreter: Klunker . Schmitt-Nilson . Hirsch
(86) Internationale Anmeldenummer: PCT/EP1995/000397
(87) Internationale Veröffentlichungsnummer: WO 1995/021423

(56) Entgegenhaltungen:
- EP-A- 0 212 506
- EP-A- 0 328 124
- EP-A- 0 493 738
- DE-A- 3 239 597
- DE-A- 4 206 445
- GB-A- 2 105 952
- US-A- 4 413 254
- US-A- 4 417 413
- US-A- 4 846 922
- US-A- 5 059 950
- "Pulp and Paper - Chemistry and Chemical Technology", Third Edition, Volume IV, John Wiley & Sons, 1983, ISBN 0-471-3178-X, p. 2351 - 2356
- "Pappersordlista", Svensk Standard, SIS 15 20 05, 01.07.1974, S. 12
- "Thesaurus", Institute of Paper Science and Technology, 1991, Atlanta USA, ISBN 08701-00-9, p. 77

## Beschreibung

Die Erfindung betrifft einen ein- oder mehrschichtigen Datenträger nach dem Oberbegriff von Anspruch 1. Desweiteren betrifft die Erfindung ein Herstellungsverfahren für solche Datenträger.

In der Vergangenheit sind verschiedene IC-Karten bekannt geworden, die nach unterschiedlichen Verfahren hergestellt werden.

So ist beispielsweise aus der EP-B1 0 140 230 eine IC-Karte bekannt, die aus mehreren Kunststoffschichten aufgebaut ist und in der sogenannten Laminiertechnik hergestellt wird. Dazu wird ein Aufbau, bestehend aus einer oberen Deckschicht, mindestens einer Kernschicht und einer unteren Deckschicht bereitgestellt. Zwischen der oberen Deckschicht und der Kernschicht wird ein elektronisches Modul, bestehend aus einem Substrat, auf dem ein integrierter Schaltkreis mit Kontaktflächen angeordnet ist, plaziert. Dieser Aufbau wird unter der Einwirkung von Wärme und Druck miteinander verbunden, wobei die Kontaktflächen des Moduls in Aussparungen der oberen Deckschicht und der integrierte Schaltkreis in einer Aussparung der Kernfolie zu liegen kommen. Der Verbund der Kunststoffschichten entsteht dadurch, daß die Schichten beim Laminieren erweichen und sich miteinander verbinden. Bei der fertiggestellten Karte ist das Modul zwischen der oberen Deckschicht und der Kernschicht eingebettet.

Aus der EP-A1 0 493 738 ist weiterhin eine IC-Karte bekannt, die in der sogenannten Montagetechnik hergestellt wird. Diese Technik zeichnet sich dadurch aus, daß zunächst ein Kartenkörper mit einer mehrstufigen Aussparung bereitgestellt wird. Danach wird das elektronische Modul in die Aussparung eingebracht und verklebt. Dies geschieht bei der EP-A1 0 493 738 mit einem thermoaktivierbaren Kleber.

Der bereitgestellte Kartenkörper kann z. B. durch Laminieren mehrerer Kunststoffschichten zunächst ohne Aussparung erzeugt werden. In einem weiteren Schritt wird dann die Aussparung z. B. durch Fräsen erzeugt.

Aus der US-A-44 17 413 ist eine IC-Karte bekannt, die im wesentlichen aus einem vielschichtigen Papierelement besteht, das den Kartenkern bildet, der mit elastischen Deckfolien kaschiert ist. Die Deckfolien dienen dazu, das den IL-Chip aufnehmende Modul in einem Fenster der Karte zu halten.

Aus der DE-A-42 06 445 ist eine Telefonkarte bekannt, die aus einem Träger in Kartenform aus üblichem Kunststoffmaterial besteht. Auf dem Träger ist eine auswechselbare Telefonmarke, im Format etwa einer Briefmarke angeordnet, die aus Papier besteht.

Der Kartenkörper kann aber auch anderweitig hergestellt werden. So ist es beispielsweise aus der DE-A1 41 42 392 bekannt geworden, den Kartenkörper in Spritzgußtechnik zu fertigen. Hierfür wird eine Spritzgußform verwendet, deren Formraum der Form eines Kartenkörpers entspricht. Während des Spritzgußvorganges wird nach nahezu vollständiger Füllung des Formraums die Aussparung im Kartenkörper mit einem beweglichen Stempel erzeugt, der in den Formraum eingefahren werden kann. Nach der Fertigstellung des Kartenkörpers wird in einem zweiten Schritt das elektronische Modul eingeklebt.

Alternativ ist es möglich, den beweglichen Stempel direkt dazu zu nutzen, das Modul in die noch nicht erhärtete Kunststoffmasse des Kunststoffkörpers zu drücken. In diesem Fall ist die Herstellung des Kartenkörpers und die Einbettung des Moduls in einem Arbeitsgang abgeschlossen.

In Spritzgußtechnik hergestellte IC-Karten sind auch aus der EP-B1 0 277 854 bekannt. Dort wird vorgeschlagen, das elektronische Modul bereits während des Einspritzvorgangs der Kunststoffmasse in die Spritzgußform einzulegen. Das Modul wird durch von außen angelegte Saugluft in der Spritzgußform fixiert. Der Gußkörper des Moduls, der den integrierten Schaltkreis schützt, ist schräg geformt und wird so durch das umgebende Spritzgußmaterial sicher im Kartenkörper gehalten.

Zusätzlich zu den Verfahrensschritten zur Herstellung des Kartenkörpers und zur Einbettung des Moduls gemäß DE-A1 41 42 392 oder EP-B1 0 277 854 sind für die Aufbringung von Druckbildern auf die Kartenoberfläche weitere Maßnahmen vorzusehen. Aus der EP-B1 0 412 893 ist hingegen ein Spritzgußverfahren zur Herstellung von IC-Karten bekannt, bei dem die IC-Karte während des Spritzgießens auch bereits mit einem grafischen Element versehen werden kann. Dazu wird eine kartengroße Papierschicht, die beidseitig bedruckt ist, in die Gußform eingelegt. Danach wird in die Gußform ein transparentes Kunststoffmaterial eingespritzt, so daß bei dem fertiggestellten Kartenkörper das Druckbild von beiden Kartenseiten zu sehen ist. Bei dem Verfahren kann eine Aussparung für das elektronische Modul entweder durch einen in die Gußform ragenden Stempel erzeugt werden, oder aber es kann das Modul direkt in der Gußform fixiert und umspritzt werden.

Bei den genannten Verfahren besteht der ein- oder mehrschichtige Kartenkörper aus Kunststoffmaterial. Bei der Laminiertechnik werden die Kartenschichten dabei unter der Einwirkung von Wärme und Druck miteinander verbunden und abschließend wieder abgekühlt. Dafür ist ein relativ hoher Zeitaufwand notwendig. Obwohl derartige Karten im Stapel sogenannter Mehrnutzenbögen "paketweise" hergestellt werden und obwohl das elektronische Modul bei der Verschweißung der Kunststoffschichten bereits miteinlaminiert werden kann, ist der Durchsatz der fertiggestellten Karten pro Zeiteinheit doch stark begrenzt. Diese Begrenzung schlägt sich natürlich auch im Kartenpreis nieder.

Bei der Spritzgußtechnik ist die Herstellung des Kartenkörpers bzw. der IC-Karte relativ einfach und mit geringerem Zeitaufwand zu realisieren. Die Anlagen für die Fertigung von Spritzgußkörpern bzw. Spritzgußkarten haben jedoch einen hohen Anschaffungspreis. Darüber hinaus sind diese Anlagen vorwiegend für die Einzelkartenfertigung konzipiert, so daß der Durchsatz pro Zeiteinheit in der selben Größenordnung wie bei laminierten Karten bleibt.

Aus dem oben gesagten folgt, daß eine weitere Kostensenkung des Stückpreises einer IC-Karte mit den bisher zur Herstellung der IC-Karte verwendeten Techniken, wenn überhaupt, nur noch in einem geringen Umfang möglich ist.

Es ist deshalb Aufgabe der Erfindung, eine IC-Karte vorzuschlagen, bei der der Kartenaufbau und das Verfahren zur Herstellung der Karte eine weitere Kostenreduzierung ermöglichen.

Die Aufgabe wird durch die kennzeichnenden Merkmale des Hauptanspruchs gelöst.

Die Vorteile der Erfindung sind insbesondere darin zu sehen, daß die für den Kartenaufbau benötigten Papierschichten, unabhängig davon, ob es sich bei der Karte um eine Einschicht- oder Mehrschichtkarte handelt, von der Rolle bereitgestellt werden können und die Papier-IC-Karte somit in Endlostechnik zu fertigen ist. Hierbei ist eine Verklebung mehrerer Schichten sehr einfach möglich, da die entweder kalt oder mit Hilfe dünner thermoaktivierbarer Kleber verklebten Schichten ohne aufwendige Wartezeiten gefertigt werden können. Darüber hinaus können sämtliche aus der herkömmlichen Papierverarbeitung bekannten Technologien auf die Herstellung der Papier-IC-Karte übertragen werden, sowohl was die Verbindung der einzelnen Kartenschichten als auch was die Bedruckung der Kartenschichten anbelangt. So können beispielsweise die aus der Papiertechnik bekannten Drucktechniken kostengünstig, z. B. durch Rollen- oder Bogenbedruckung der Schichten eingesetzt werden. Hierbei sind alle aus der Papiertechnik bekannten Druckqualitäten erreichbar. Ferner ist die Papier-IC-Karte im Gegensatz zur Kunststoffkarte umweltschonend und recycelfähig. Ein weiterer Vorteil der IC-Karte ist, daß sie je nach verwendetem Kleber eine hohe Thermostabilität aufweist. Ferner ist die Papier-IC-Karte aufgrund ihrer saugfähigen Oberfläche in einfacher Art und Weise mit individuellen Daten zu versehen, beispielsweise mit einem Tintenstrahldrucker. Schließlich kann die Papier-IC-Karte mit allen Sicherheitsmerkmalen versehen werden, die aus dem Wertpapierbereich bekannt geworden sind. Beispielsweise wäre es möglich, eine der Papierschichten mit einem aus dem Banknotenbereich bekannten Sicherheitsfaden zu versehen und diesen in die Karte zu integrieren.

Wie der Stand der Technik belegt, hat sich die gesamte, nunmehr fast 20jährige Entwicklung der IC-Karte an Kunststoff als Material für den Kartenkörper orientiert. Dies ist deswegen unmittelbar verständlich, da mit Kunststoff ein Material ausgewählt worden ist, das sowohl langlebig ist als auch eine hohe Widerstandsfähigkeit aufweist.

Im Laufe der Entwicklung der IC-Karte sind allerdings auch Anwendungen bekannt geworden, bei denen die Karten auch für kürzere Laufzeiten eingesetzt werden. Als Beispiel für eine solche Anwendung sei die Telefonkarte genannt. Es wurde aber auch bei der Wahl für das Kartenmaterial von Telefonkarten der Kunststoff einfach übernommen. Es bestand also offensichtlich ein Vorurteil in der Fachwelt, andere Materialien als Kunststoff für die Herstellung von Karten mit integriertem Schaltkreis überhaupt in Betracht zu ziehen, weil man nur mit diesem Material glaubte, Karten herstellen zu können, die den notwendigen Schutz für den empfindlichen IC-Baustein bieten. Trotz der obengenannten erheblichen Vorteile, die eine Karte aus Papier oder Karton bietet, wurde jedenfalls dieses Material bisher zur Herstellung von Karten mit integriertem Schaltkreisen nicht in Betracht gezogen.

In einem bevorzugten Ausführungsbeispiel der Erfindung wird zunächst ein Papierkartenkörper hergestellt, in den das elektronische Modul später eingeklebt wird. Hierbei kann der Kartenkörper aus mehreren Papierschichten oder aus einer Kartonschicht bestehen.

In einem weiteren Ausführungsbeispiel der Erfindung wird das elektronische Modul während der Herstellung der Karten in den Kartenkörper einlaminiert. Hierbei kann das Modul entweder zwischen zwei Schichten eingebettet oder aber auch in einer Aussparung eingeklebt werden.

In einem weiteren bevorzugten Ausführungsbeispiel wird ein elektronisches Modul, das für einen nichtberührenden Datenaustausch geeignet ist, während des Laminiervorgangs mehrerer Kartenschichten in eine Aussparung der Kernschicht eingebracht.

In Zusammenhang mit den nachstehenden Figuren werden Ausführungsbeispiele und weitere Vorteile der Erfindung näher erläutert, darin zeigt:
- Fig. 1: eine IC-Karte in Aufsicht
- Fig. 2: einen Querschnitt durch einen Kartenkörperschichtaufbau
- Fig. 3: einen Querschnitt durch einen Kartenkörper mit einer Aussparung
- Fig. 4: einen Schichtaufbau für eine in Laminiertechnik herzustellende Karte im Querschnitt
- Fig. 5: einen Schichtaufbau einer Karte im Querschnitt
- Fig. 6: den Schichtaufbau aus Fig. 5 im Querschnitt, jedoch mit einer Aussparung
- Fig. 7: einen Schichtaufbau einer Karte vor dem Verbund der einzelnen Schichten im Querschnitt
- Fig. 8: den Schichtaufbau aus Fig. 7 im Querschnitt, wobei die Kartenschichten miteinander verbunden sind
- Fig. 9: eine IC-Karte im Querschnitt
- Fig. 10: einen Kartenkörper mit Aussparung im Querschnitt
- Fig. 11: eine IC-Karte im Querschnitt
- Fig. 12: einen Schichtaufbau für eine in Laminiertechnik herzustellende Karte im Querschnitt
- Fig. 13: eine IC-Karte im Querschnitt
- Fig. 14: eine IC-Karte im Querschnitt
- Fig. 15: eine IC-Karte im Querschnitt
- Fig. 16: eine IC-Karte im Querschnitt
- Fig. 17: ein Verfahren zur Herstellung einer IC-Karte
- Fig. 18: eine mehrschichtiges Endlosband in Aufsicht
- Fig. 19: einen Querschnitt aus Fig. 18
- Fig. 20: eine IC-Karte in Aufsicht
- Fig. 21: einen Stapel von IC-Karten im Querschnitt.

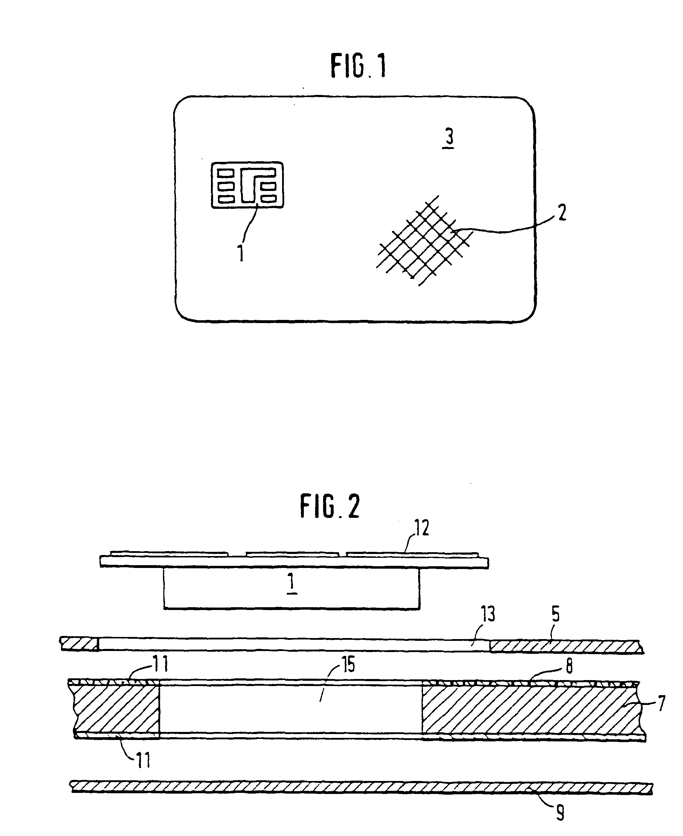

Fig. 1 zeigt eine IC-Karte mit einem elektronischen Modul 1 in einem Kartenkörper 3 in Aufsicht. Der Kartenkörper 3 verfügt über Abmessungen, die in einer ISO-Norm mit der Bezeichung ISO 7810 festgelegt sind. Das elektronische Modul 1 ist an einer definierten Position in den Kartenkörper eingebettet, die ebenfalls durch eine ISO-Norm mit der Bezeichnung ISO 7816/2 festgelegt ist. Erfindungsgemäß ist der Kartenkörper 3 der IC-Karte aus einer bzw. aus mehreren Papier- und/oder Kartonschichten hergestellt.

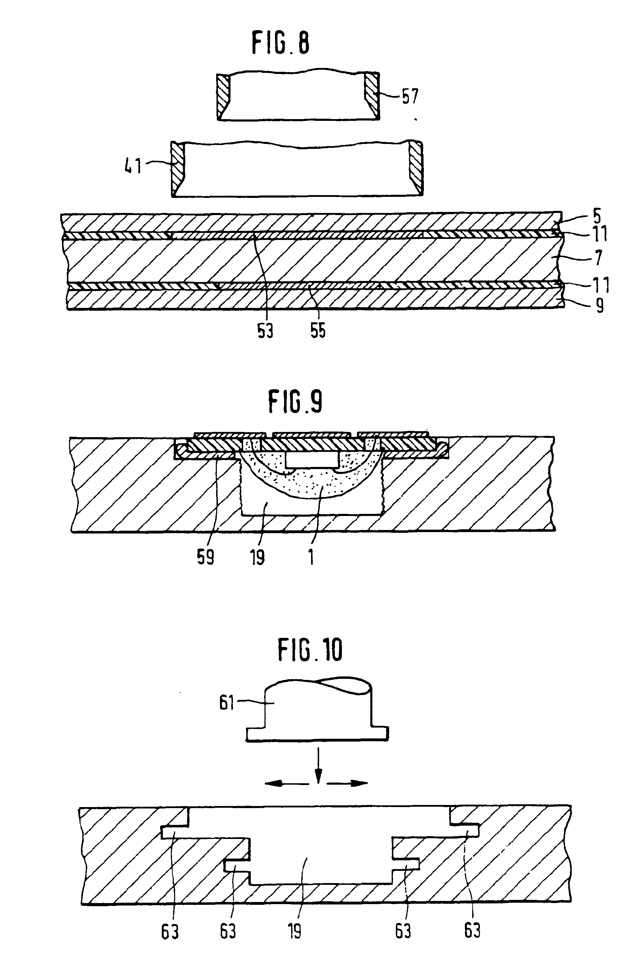

Fig. 2 zeigt einen mehrschichtigen Kartenaufbau im Querschnitt vor der Laminierung der einzelnen Kartenschichten. Der Kartenaufbau besteht aus einer oberen Deckschicht 5, einer Kernschicht 7 und einer unteren Deckschicht 9. Die Kernschicht 7 ist beidseitig mit einer dünnen thermoaktivierbaren Klebeschicht 11 versehen, mit Hilfe derer die Schichten verklebt werden. Vor dem Zusammenführen der einzelnen Schichten werden in die Schichten 5 und 7 Fenster 13 bzw. 15 eingestanzt, so daß nach dem Zusammenführen und Verkleben der drei Schichten eine zweistufige Aussparung in dem Kartenkörper entsteht. Bei der Verwendung mehrerer Kernschichten ist es auch möglich, im Kartenkörper eine mehrstufige Aussparung zu erzeugen, wobei die Fenster in den einzelnen Kernschichten von der oberen Deckschicht betrachtet immer kleiner werden. Ein solcher Kartenaufbau ist dann besonders vorteilhaft, wenn die Gußmasse des elektronischen Moduls tropfenförmig ausgebildet ist, wie es z.B. in der Fig. 9 gezeigt ist, da dann die Konturen der Aussparung gut an die Form der Gußmasse anpaßbar und der Bodenbereich der Aussparung klein ausgebildet ist.

Die Fertigung des Kartenlaminats kann in großen Durchsätzen erfolgen. So können die Schichten 5, 7 und 9 von Rollen bereitgestellt werden und zur Laminierung durch geheizte Laminierrollen geführt werden, zwischen denen die thermoaktivierbaren Klebeschichten aktiviert werden. Es entsteht also ein Endloslaminat, das in entsprechenden Abständen mit den Aussparungen zur Aufnahme des elektronischen Moduls versehen ist. Aus diesem Endloslaminat werden in einem weiteren Verfahrensschritt die einzelnen Kartenkörper ausgestanzt. In die Aussparung des Kartenkörpers werden die elektronischen Module 1 eingeklebt. Der notwendige Kleber kann sich entweder am Modul direkt befinden oder z. B. in Form eines Flüssigklebers in die Aussparung eingebracht werden. Der Einbau des Moduls in den Kartenkörper ist vor oder nach dem Ausstanzen der Karte möglich.

Um die Verbundfähigkeit zwischen dem Modul und dem Kartenkörper zu erhöhen, kann anstatt des oberhalb der Kartenschicht liegenden thermoaktivierbaren Klebers 11 die Kernschicht 7 mit einem Gewebe 8 versehen werden, das mit einem thermoaktivierbaren Kleber getränkt ist. In der Fig. 2 ist das Gewebe durch die Punkte in der oberen thermoaktivierbaren Schicht 11 angedeutet. Das Gewebe kann so gewählt werden, daß es eine optimale Verbundfestigkeit zwischen dem elektronischem Modul und dem Kartenkörper erlaubt. Bei der fertiggestellten Karte befindet sich das Gewebe also zwischen der Deckschicht 5 und der Kernschicht 7. Durch die feste Verbindung des Moduls mit dem Gewebe ist bei der fertiggestellten IC-Karte das Modul also zwischen den Kartenschichten verankert. Alternativ zu einem Gewebe, das sich ganzflächig auf der Kernschicht 7 befindet, ist auch möglich, die Kernschicht 7 nur im Bereich des Fensters 15 mit einem Gewebe oder einer Folie zu versehen. Hiermit sind die obengenannten Effekte auch zu erzielen.

Das in der Fig. 2 gezeigte Modul trägt auf seiner Oberfläche 12 Kontaktflächen für die berührende Kontaktabnahme. Alternativ kann die IC-Karte auch mit einem elektronischen Modul versehen werden, das für einen berührungslosen Datenaustausch geeignet ist. Ein solches Modul kann in dem Fenster 15 eingelegt werden. In diesem Fall kann also auf das Fenster 13 in der Deckschicht 5 verzichtet werden, so daß bei der fertiggestellten IC-Karte das Modul für den berührungslosen Datenaustausch in dem Fenster 15 zwischen den Deckschichten 5 und 9 liegt.

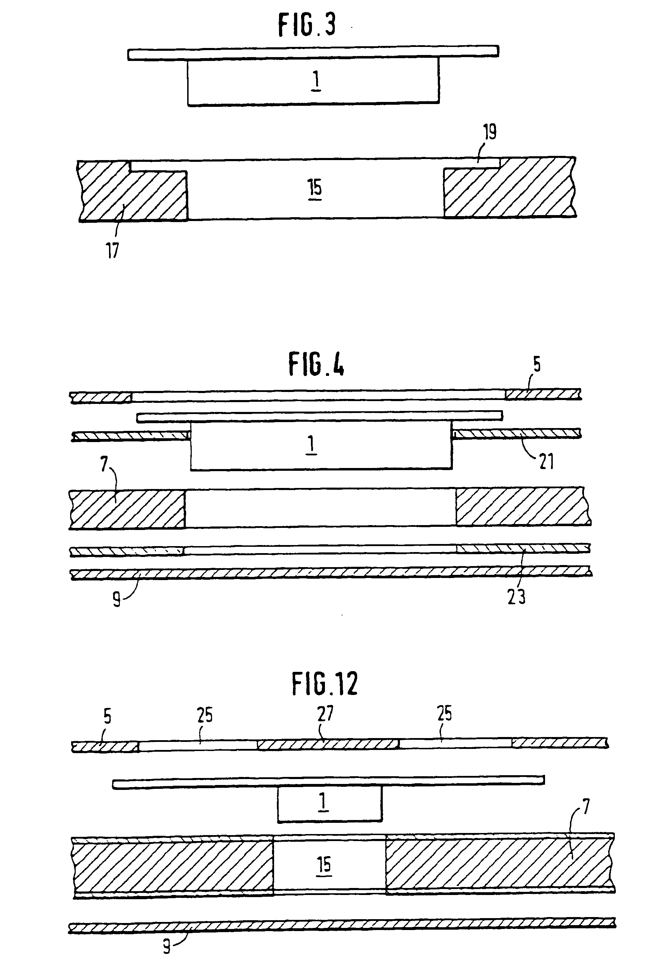

Fig. 3 zeigt den Kartenkörper einer einschichtigen Kartonkarte im Querschnitt. Der Karton 17 kann ebenfalls von einer Rolle bereitgestellt werden. In den Karton werden in entsprechenden Abständen Fenster 15 eingestanzt. Ferner wird durch Tiefprägung des Kartons 17 im Bereich des Fensters 15 eine Aussparung 19 geringer Tiefe erzeugt, die einen größeren Durchmesser als das Fenster 15 aufweist. In die entstandene Aussparung des Kartons kann das elektronische Modul 1 eingeklebt werden, wobei als Klebeschicht der Boden der Aussparung 19 genutzt wird. Das Modul kann wiederum mit Hilfe eines am Modul befindlichen Klebers, der als thermoaktivierbarer Kleber oder als Haftkleber ausgebildet sein kann, oder mit Hilfe eines Flüssigklebers in die Aussparung eingeklebt werden. Die Karte kann vor oder nach dem Einkleben aus dem Endloskarton ausgestanzt werden. Bei der fertiggestellten IC-Karte kann sich auf der Rückseite der Karte im Modulbereich noch ein Teil des Fensters 15 befinden, der nicht durch das Modul ausgefüllt ist. Um der Karte ein besseres Aussehen zu verleihen, kann dieser Teil noch zusätzlich, z. B. durch Vergießen mit einer Gußmasse oder durch andere Maßnahmen geschlossen werden.

Fig. 4 zeigt wiederum einen mehrschichtigen Kartenaufbau vor dem Laminieren im Querschnitt. Die Schichten 5, 7 und 9 sind identisch mit denen aus der Fig. 2. Zusätzlich zu diesen Schichten weist der Aufbau noch separate Klebeschichten 21 und 23 auf, die auch mit entsprechenden Stanzungen versehen sind.

Die Klebeschichten 21 und 23 können entweder als thermoaktivierbare Schichten oder als Haftkleberschichten ausgebildet sein. Im letzteren Fall müssen die Fenster in den Schichten erstellt werden, wenn die Schichten noch mit einem Silikonband beschichtet sind, um ein Verkleben der Stanzwerkzeuge zu vermeiden. Nach dem Stanzen der Fenster können die Silikonbänder von den Haftklebeschichten abund auf bereitgestellte Rollen aufgerollt werden.

Das elektronische Modul 1 kann bereits vor der Rollenlaminierung in die Fenster der Klebeschicht 21 derart eingelegt werden, daß der Kontaktflächenbereich auf der Klebeschicht 21 aufliegt und der Bereich des Moduls, der den integrierten Schaltkreis aufnimmt, sich in dem Fenster befindet, so wie es in der Figur gezeigt ist. Bei dem Laminieren der gezeigten Kartenschichten wird das gezeigte Modul also gleichzeitig mit der Klebeschicht 21 in der Aussparung des Kartenkörpers verklebt.

Falls das elektronische Modul nicht bei der Laminierung des Kartenkörpers in die Aussparung eingeklebt werden soll, ist es auch möglich, das Fenster in der Klebeschicht 21 genau so groß auszustanzen wie das Fenster in der Deckschicht 5. In diesem Fall bleibt die Schulter der zweistufigen Aussparung beim Laminieren der Schichten frei von der Kleberschicht, so daß bei der Erwärmung dieser Schicht kein Klebermaterial auf die Oberfläche der Karte dringen kann. Eine solche Ausführungsform ist besonders vorteilhaft, wenn der ausgestanzte Kartenkörper als Zwischenprodukt gelagert werden soll. Auch der in der Fig. 4 gezeigte Kartenaufbau ist besonders zur Einbettung eines Moduls für den berührungslosen Datenaustausch geeignet. In diesem Fall kann wiederum auf die Fenster in den Schichten 5 und 21 verzichtet werden.

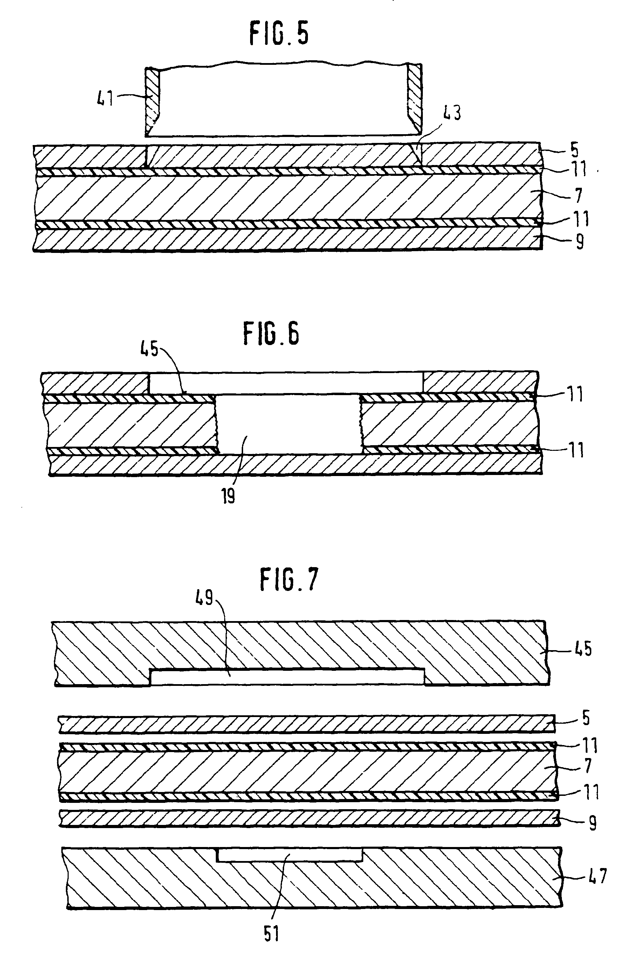

Die Fig. 2 und 4 zeigen mehrschichtige Kartenaufbauten, bei denen die einzelnen Schichten bereits vor dem Zusammenfügen über Fenster verfügen, die sich nach dem Zusammenfügen der Schichten zu einer Aussparung im Kartenkörper ergänzen. Im Gegensatz dazu zeigen die Fig. 5-8 Ausführungsbeispiele, bei denen die Aussparung nachträglich in den Kartenkörper eingebracht wird.

Fig. 5 zeigt einen Kartenaufbau, der aus einer Kernschicht 7 und den Deckschichten 5 und 9 besteht, wobei die Schichten durch thermoaktivierbare Klebeschichten 11 miteinander verbunden sind. Als thermoaktivierbare Klebeschichten können z.B. extrem dünne Polyethylen (PE)-Folie oder amorphe Polyethylenterephthalat (APET)-Folie verwendet werden, die beidseitig auf die Kernschicht 7 aufgebracht werden. In der Deckschicht 5 wird zunächst mit einem Schneidewerkzeug 41 eine Schnittkante 43 erzeugt, die den Rand des ersten Teils einer zweistufigen Aussparung festgelegt. Danach wird mit einem Fräswerkzeug in dem Kartenkörper die in der Fig. 6 gezeigte zweistufige Aussparung 19 derart erzeugt, daß auf der Schulter 45 die thermoaktivierbare Klebeschicht 11 freigelegt wird.

Die Verwendung eines Schneidwerkzeuges zur Erzeugung der Schnittkante 43 hat den Vorteil, daß im sichtbaren Bereich der fertiggestellten Chipkarte ein sauberer und optisch einwandfreier Rand entsteht, wohingegen es bei der Verwendung eines Fräswerkzeuges zur Herstellung einer Aussparung im Papier nicht vermieden werden kann, daß es an den Rändern zu "Ausfransungen" kommt, so wie es in der Fig. 6 im Randbereich des unteren Teils der zweistufigen Aussparung angedeutet ist. Selbstverständlich ist es auch möglich, auf den Einsatz eines Schneidewerkzeuges zu verzichten und die Aussparung ausschließlich mit einem Fräswerkzeug zu erzeugen.

In die zweistufige Aussparung 19 des Kartenkörpers (siehe Fig. 6) wird ein elektronisches Modul, wie es beispielsweise in der Fig. 2 gezeigt ist, eingebracht und auf der Schulter 45 mit Hilfe der beim Fräsvorgang freigelegten thermoaktivierbaren Klebeschicht 11 verklebt. Selbstverständlich ist es auch möglich, das elektronische Modul zusätzlich mit einem Kleber zu versehen, um den Verbund zum Kartenkörper zu verbessern. Dies ist dann besonders vorteilhaft, wenn die thermoaktivierbaren Klebeschichten 11 sehr dünn ausgebildet sind und die Klebeschicht 11 im Schulterbereich 45 der Aussparung beim Fräsvorgang beabsichtigt oder unbeabsichtigt beschädigt bzw. beseitigt wird.

Fig. 7 zeigt den gleichen Schichtaufbau wie Fig. 5, jedoch sind die Deckschichten 5 und 9 noch nicht mit der Kernschicht 7 verbunden. In dem gezeigten Ausführungsbeispiel werden die Kartenschichten mit Heizstempeln 45 und 47 unter der Einwirkung von Wärme und Druck miteinander verbunden, wobei die Heizstempel 45 und 47 in dem Bereich, in dem nachträglich die Aussparung im Kartenkörper erzeugt wird, Aussparungen 49 und 51 aufweisen. Im Bereich dieser Aussparungen werden also beim Verbinden der Schichten die thermoaktivierbaren Schichten 11 nicht aktiviert, so daß in diesem Bereich kein Verbund zwischen den Kartenschichten erstellt wird.

Fig. 8 zeigt den Kartenaufbau aus Fig. 7, wobei die einzelnen Kartenschichten nunmehr miteinander verbunden sind. Durch die spezielle Ausbildung der Heizstempel hat sich die Deckschicht 5 mit der Kernschicht 7 im Bereich 53 und die Deckschicht 9 mit der Kernschicht 7 im Bereich 55 nicht miteinander verbunden. Mit Hilfe des Schneidwerkzeuges 41 kann nun der obere Teil einer zweistufigen Aussparung erzeugt werden, indem man das Schneidwerkzeug 41 zunächst mindestens so weit in den Kartenkörper einführt, daß die Deckschicht 5 durchtrennt ist. Der innerhalb der Schnittkante liegende Teil der Deckschicht läßt sich danach einfach entfernen, da dieser Teil keinen Verbund mit der Klebeschicht 11 eingegangen ist. Der untere Teil der zweistufigen Aussparung 19 läßt sich auf analoge Art und Weise mit dem Schneidwerkzeug 57 erzeugen. Es entsteht also ein Kartenkörper, wie er bereits in der Fig. 6 gezeigt ist, mit einer zweistufigen Aussparung, die jedoch im gesamten Wandbereich über saubere Schnittkanten verfügt. Selbstverständlich ist das beschriebene Verfahren nicht auf die Herstellung einer zweistufigen Aussparung beschränkt. Vielmehr können in analoger Art und Weise auch stufenlose bzw. mehrstufige Aussparungen im Kartenkörper erzeugt werden.

Das im Zusammenhang mit den Fig. 7 und 8 beschriebene Herstellungsverfahren ist besonders für Kartenkörper, die ausschließlich aus Papier und Karton bestehen, geeignet, da die einzelnen Papierschichten beim Verbinden nicht erweicht werden, wie dies beim Laminieren von Kunststoffschichten geschieht. Mit Hilfe der gezeigten Heizstempel wird die Wärme lediglich durch das Papier zu den thermoaktivierbaren Klebeschichten geleitet, die daraufhin aktiviert werden. Die Papierschichten selbst bleiben also während des gesamten Herstellungsverfahrens formstabil, so daß es auch an den Übergängen zu den nicht beheizten Bereichen (siehe Fig. 7) zu keinerlei Verzerrungen der Papierschichten kommt. Der Bodenbereich der zweistufigen Aussparung ist beim fertiggestellten Kartenkörper somit sehr plan ausgebildet.

Fig. 9 zeigt einen einschichtigen Kartenkörper mit einer zweistufigen Aussparung 19, in die ein elektronisches Modul 1 mit einem Flüssigkleber 59 eingeklebt ist. Im täglichen Gebrauch der Chipkarten kommt es zu Biegebelastungen, die auf den Kartenkörper auch im Bereich des elektronischen Moduls einwirken. Aufgrund dieser Biegebelastungen kann es bei dem in der Fig. 9 gezeigten Ausführungsbeispiel wegen der Spaltbarkeit von Papier dazu kommen, daß sich das Papier im Schulterbereich 45 (siehe Fig. 6) in der Aussparung 19 direkt unterhalb des Flüssigklebers spaltet und sich dadurch das elektronische Modul im Laufe der Zeit aus dem Kartenkörper löst.

Obwohl Chipkarten aus Papier vorzugsweise für Anwendungen, bei denen die Karte nur eine kurze Lebensdauer aufzuweisen braucht, verwendet werden sollen und somit ein Kartenaufbau wie in Fig. 9 gezeigt an sich langlebig genug ist, läßt sich der Verbund zwischen dem elektronischen Modul und dem Kartenkörper dadurch verbessern, daß man die zweistufige Aussparung 19 mit einem geeigneten Fräswerkzeug 61 mit Hinterschneidungen 63 versieht, so wie es in der Fig. 10 gezeigt ist.

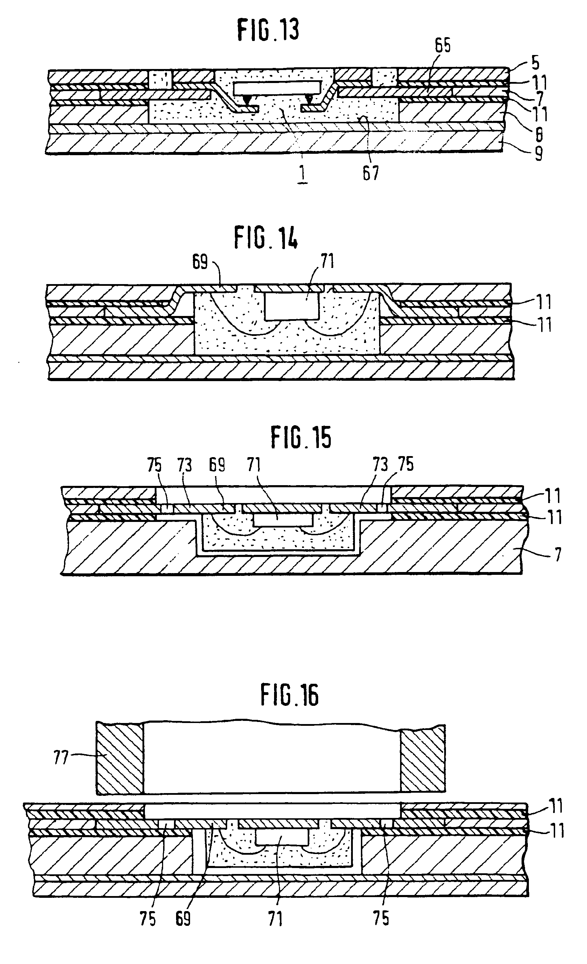

In die zweistufige Aussparung 19 wird eine dosierte Menge Flüssigkleber 59 eingebracht, die sich beim Einbringen des elektronischen Moduls 1 in der Aussparung 19 so verteilt, daß auch die Hinterschneidungen 63 mit Flüssigkleber 59 gefüllt sind (siehe Fig. 10 und 11). Somit ist das elektronische Modul 1 im Kartenkörper verankert und gegen senkrecht zur Kartenoberfläche wirkende Kräfte gesichert. Darüber hinaus bietet der Flüssigkleber, der nunmehr den gesamten Wandbereich der Aussparung benetzt, auch einen guten Schutz vor dem Aufspalten des Papiers in diesem Bereich. Alternativ ist es selbstverständlich auch möglich, auf die Hinterschneidungen zu verzichten und den Flüssigkleber so zu dosieren, daß der Wandbereich bei der fertiggestellten Karte weitgehend bzw. vollständig von ihm benetzt ist.

Fig. 12 zeigt wiederum einen mehrschichtigen Kartenkörper vor der Laminierung im Querschnitt. Die einzelnen Schichten 5, 7 und 9 sind mit den in der Fig. 2 gezeigten Schichten identisch. Die obere Deckschicht 5 weist jedoch anstatt des Fensters 13 zwei Fenster 25 auf, die durch einen Steg 27 getrennt sind. Das elektronische Modul 1 wird vor dem Laminieren so in das Fenster 15 der Kernschicht 7 eingelegt, wie es der Fig. 12 zu entnehmen ist. Bei der Rollenlaminierung der Schichten wird das Modul 1 mit der Schicht 7 verklebt und zusätzlich zwischen den Schichten 5 und 7 eingebettet. Bei der fertiggestellten IC-Karte liegen die Kontakflächen des Moduls 1 in den Fenstern 25 und die Einbettung zwischen den Schichten wird durch den Steg 27 herbeigeführt. Ein Modul, das für die obengenannte Herstellungstechnik besonders geeignet ist, ist in der EP-B1 0 140 230 genau beschrieben.

Die Fig. 13-16 zeigen weitere Ausführungsbeispiele, bei denen das elektronische Modul durch das Einbetten von Teilen des Moduls zwischen zwei Kartenschichten bereits bei der Herstellung der Karte im Kartenkörper verankert wird.

Fig. 13 zeigt einen mehrschichtigen Kartenaufbau, bestehend aus den Deckschichten 5 und 9 und den Kernschichten 7 und 8. Das in den gezeigten Kartenaufbau eingebrachte elektronische Modul 1 verfügt über einen Verankerungsrahmen 65, der über den Gußkörper 67 des Moduls hinausragt und der bereits während der Herstellung der Karten zwischen den beiden Kartenschichten 5 und 7 eingebettet wird. Wie in der Fig. 13 gezeigt, ist der Verankerungsrahmen 65 beidseitig von thermoaktivierbaren Klebeschichten umgeben, so daß ein guter Verbund zwischen dem Verankerungsrahmen und dem Kartenkörper entsteht. In einem bevorzugten Ausführungsbeispiel ist der Verankerungsrahmen als Gewebe ausgebildet, in das bei der Kartenherstellung Klebematerial aus den angrenzenden Klebeschichten 11 eindringen kann. Dadurch kommt es zu einem indirekten Verbund der angrenzenden Klebeschichten 11 und zu einer verbesserten Verankerung des Moduls im Kartenkörper.

Die Fig. 14-16 zeigen weitere Ausführungsbeispiele, bei denen das elektronische Modul zwischen zwei Kartenschichten eingebettet ist. Die Module weisen in diesen Figuren alle denselben Aufbau auf und werden allgemein als Lead-frame-Module bezeichnet. Sie bestehen aus einem Metallplättchen 69, in dem ein Kontaktlayout ausgebildet ist und auf dessen einer Seite ein IC-Baustein 71 aufgebracht ist, der leitend mit den Kontaktflächen des Kontaktlayouts verbunden ist. Der IC-Baustein und die leitenden Verbindungen sind zum Schutz vor mechanischen Belastungen von einer Gußmasse umgeben. Bei den gezeigten Ausführungsbeispielen wird der Verankerungsrahmen durch Verlängerungen der Kontaktflächen gebildet, die über das eigentliche Kontaktlayout hinausragen und zwischen zwei Kartenschichten eingebettet sind.

Fig. 14 zeigt an sich den gleichen Kartenaufbau wie Fig. 13. Der Verankerungsrahmen wird bereits bei der Herstellung der Karte, also beim Verbinden der einzelnen Schichten, in das Karteninnere gekröpft, so daß der in der Fig. 14 gezeigte Aufbau entsteht. Die Herstellung erfolgt also analog zu der Herstellung, wie sie bereits in Verbindung mit Fig. 12 erläutert wurde.

Fig. 15 zeigt eine Chipkarte im Querschnitt, bei der der Verankerungsrahmen des Leadframe-Moduls nicht gekröpft ist und die Kontaktflächen 73 des elektronischen Moduls unterhalb der Kartenoberfläche liegen. Die Kontaktflächen können im Übergangsbereich zu den Verlängerungen, die der Verankerung dienen, mit Entlastungsstanzungen 75 versehen werden, so daß sie nur über dünne Stege mit den Verlängerungen verbunden bleiben. Dies führt zu einer mechanischen Entkopplung des Übergangsbereiches Modul/Verankerungsrahmen und somit zu einer Entlastung in diesem Bereich bei Biegebelastungen der Karte, so daß sich die Klebeschicht 11, z. B. durch Einreißen bzw. Aufspalten der darunterliegenden Kartenschicht 7, nicht so schnell von dieser Kartenschicht löst.

Fig. 16 zeigt an sich denselben Querschnitt wie Fig. 15. Die unterhalb des Verankerungsrahmens verlaufende Klebeschicht 11 führt jedoch bis an den Randbereich des unteren Teils der zweistufigen Aussparung heran, wodurch eine größere Klebefläche zur Verklebung des elektronischen Moduls erreicht wird. Ferner ist in der Fig. 16 ein Heizstempel 77 gezeigt, mit Hilfe dessen der Verbund zwischen den Verankerungsrahmen und den Klebeschichten 11 in einer separaten Station nochmals verbessert werden kann.

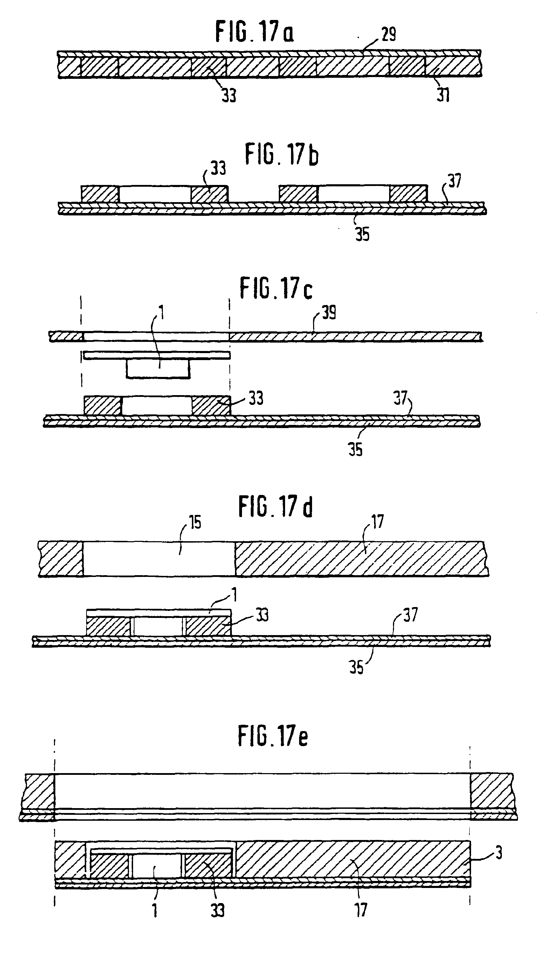

Fig. 17 zeigt schließlich ein Herstellungsverfahren für eine Papier-IC-Karte, die aus zwei Schichten besteht, die mittels eines Haftklebers verbunden werden. In einem ersten Verfahrensschritt (Fig. 17a) werden aus einem mit einem Silikonband 29 beschichteten Haftklebeband 31 Verbundelemente 33 hergestellt. Dies geschieht mit aus der Etikettiertechnik bekannten Verfahren, die dem Fachmann geläufig sind und hier nicht näher erläutert zu werden brauchen. Zusätzlich ist die Erstellung solcher Verbundelemente aus der DE-OS 41 22 049 bekannt. Das mit den Verbundelementen 33 versehene Silikonband 29 wird mit einer Papierschicht 35 zusammengeführt, die mit einer Haftkleberschicht 37 versehen ist. Da die Haftung des Verbundelements an der Haftkleberschicht größer als an der Silikonschicht ist, läßt sich das Verbundelement auf das Haftkleberband 37 übertragen, so daß sich das in der Fig. 17b gezeigte Zwischenprodukt ergibt. Bei einem weiteren Verfahrensschritt (Fig. 17c) werden elektronische Module 1 aus einem Modulband 39 ausgestanzt und mit dem Verbundelement 33 verklebt. Das in der Fig. 17c gezeigte Zwischenprodukt wird mit einem vorgestanzten Kartonband 17 mit Fenstern 15 derart zusammengeführt, daß die auf der Papierschicht 35 aufgeklebten Module in den Fenstern zu liegen kommen. Schließlich werden, wie in Fig. 17e gezeigt, die fertiggestellten Papier-IC-Karten 3 aus dem Endlosband ausgestanzt. Selbstverständlich ist es auch möglich, die Papierkarte einzeln zu fertigen. In diesem Fall weisen die einzelnen in den Figuren gezeigten Kartenschichten bereits Kartengröße auf, so daß nach dem Verbinden der einzelnen Schichten bereits der Kartenkörper in den gewünschten Abmessungen entsteht.

Die bisherigen Ausführungen betreffen durchgehend Ausführungsbeispiele, bei denen bereits fertiggestellte Papier- bzw. Kartonbahnen bereitgestellt oder zusammengeführt werden und dabei oder nachträglich ein elektronisches Modul in den Kartenkörper eingesetzt wird. Alternativ ist es auch möglich, elektronische Module bereits bei der Herstellung des Kartons in diesen einzubringen. Dieses Verfahren kann besonders vorteilhaft bei elektronischen Modulen für den berührungslosen Datenaustausch, z.B. bestehend aus einer ringförmigen Spule und einem integrierten Schaltkreis, der leitend mit der Spule verbunden ist, angewendet werden, da bei diesen Modulen die Anforderungen an die Lagegenauigkeit im fertiggestellten Datenträger niedriger sind, als bei Modulen für den berührenden Datenaustausch. Ferner sind die elektronischen Module für den berührungslosen Datenaustausch allseitig von Karton umgeben und formschlüssig in diesen eingebettet, ohne daß aufwendige Maßnahmen für die Herstellung eines Kanals für die Spule des Moduls ergriffen werden müssen. Die elektronischen Module werden bevorzugt matrixförmig in den Karton eingebettet, so daß schließlich ein Mehrnutzenbogen bzw. eine Mehrnutzenbahn entsteht, aus der einzelne Datenträger mit einem Modul ausgestanzt werden. Der Bogen kann bereits bei der Herstellung mit Positionsmarkierungen versehen werden, anhand derer das Stanzwerkzeug exakt positioniert werden kann, so daß das elektronische Modul nach dem Ausstanzen lagegenau zu den Außenkanten des Datenträgers positioniert ist. Es ist ferner möglich, den Bogen vor dem Ausstanzen mit einem Druckbild zu versehen, so daß der Datenträger bereits nach dem Ausstanzen fertiggestellt ist. Alternativ ist es möglich, den mit elektronischen Modulen für den berührungslosen Datenaustausch versehenen Mehrnutzenbogen beidseitig mit bedruckten Deckschichten zu versehen und die einzelnen Datenträger danach auszustanzen. In diesem Fall können die Positionsmarkierungen für das Stanzwerkzeug in dem Druckbild einer Deckschicht vorgesehen werden, so daß auf Positionsmarkierungen in dem Karton verzichtet werden kann.

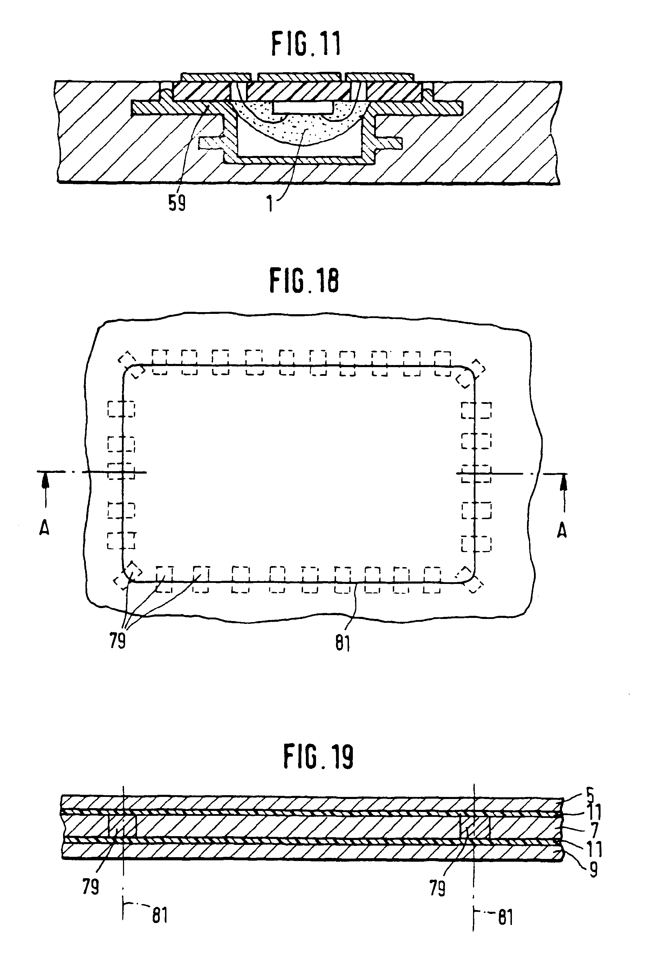

Es können unterschiedliche Maßnahmen ergriffen werden, die im Zusammenhang mit den Fig. 18-21 erläutert werden, um ein Aufspalten des Papiers oder des Kartons im Randbereich der ausgestanzten Papier-IC-Karten zu verhindern.

Fig. 18 zeigt in Aufsicht einen Ausschnitt aus einem Endlosband, das einen mehrschichtigen Aufbau, beispielsweise den in der Fig. 5 im Querschnitt gezeigten, aufweist. Die Kernschicht bzw. Kernschichten des mehrschichtigen Kartenaufbaus enthalten in dem Bereich, in dem die Stanzkante 81 der auszustanzenden Karte liegt, Durchgangslöcher 79.

Fig. 19 zeigt einen Querschnitt entlang der Linie A-A der Fig. 18. Beim Verbinden der einzelnen Kartenschichten dringt Material aus den angrenzenden thermoaktivierbaren Klebeschichten 11 in die Durchgangslöcher ein, so daß die Deckschichten 5 und 9 indirekt miteinander verbunden werden. Stanzt man nunmehr die Karte entlang der Stanzkante 81 derart aus, daß zumindest noch ein Teil eines jeden Durchgangsloches 79 im Kartenkörper liegt, so wie es in den Fig. 18 und 19 angedeutet ist, so erhält man einen Kartenrand, der im Kernbereich abwechselnd aus Papier bzw. Karton und Klebematerial aus den Klebeschichten besteht. Einem Aufspalten der Kernschicht kann somit weitgehend vorgebeugt werden.

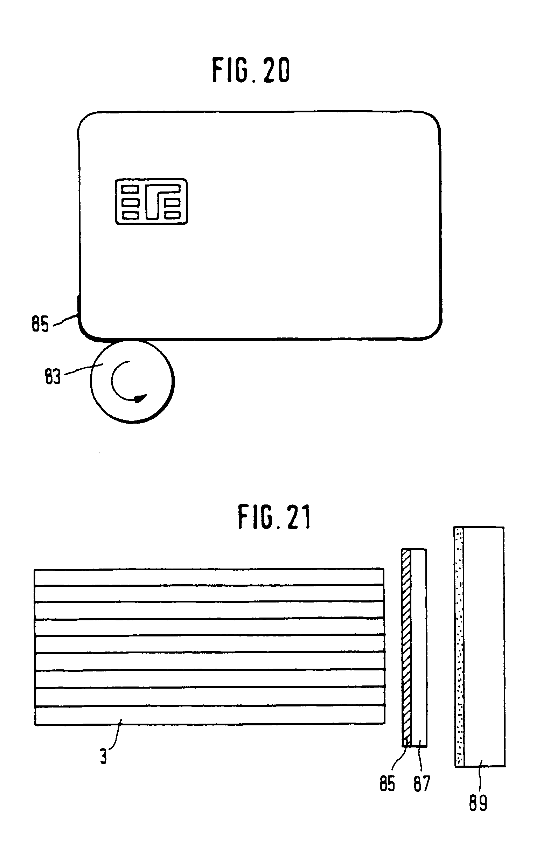

Fig. 20 zeigt eine bereits ausgestanzte Papier-IC-Karte in Aufsicht. Um den Rand der Karte vor Aufspalten zu schützen, wird auf diese ein spezieller Schutzlack 85 mit einem Auftragswerk 83 aufgetragen. Hierbei können die Karten entweder einzeln oder im Stapel zu mehreren gleichzeitig bearbeitet werden.

Fig. 21 zeigt einen Stapel aus Kartenkörpern 3 im Querschnitt, auf deren Ränder der Schutzlack 85 im Transferverfahren vom Transferband 87 mit Hilfe des Heizstempels 89 übertragen wird.

Vorzugsweise werden die Ränder der Papierkarten dann mit einem Schutzlack versehen, wenn die Karten einen einschichtigen Kartenaufbau aufweisen, da in diesem Fall das in Verbindung mit den Fig. 18 und 19 erläuterte Verfahren nicht durchführbar ist. Selbstverständlich können auch mehrschichtige Karten mit einem Schutzlack versehen werden, wobei der Schutzlack die einzige oder aber eine zusätzliche Schutzmaßnahme vor dem Aufspalten des Kartenrandes sein kann. Der Schutzlack kann farbig ausgebildet sein und als zusätzliche Kennung bzw. zusätzliches Sicherheitsmerkmal verwendet werden.

Abschließend sei erwähnt, daß bereits vor der Erstellung der IC-Karten diejenigen Schichten, die die Deckschichten der Karte bilden, mit Druckbildern etc. ganz oder bereichsweise versehen werden können, wobei alle gängigen Druckverfahren, wie z.B. Prägedruck, Reliefdruck, Offsetdruck, Stahltiefdruck, Siebdruck, Hochdruck, Heißprägedruck, Teigdruck, Tapetendruck, hektografische Druckverfahren etc. verwendbar sind. Hierbei kann durch die Verwendung von Kunstdruckpapier die auf Papier ohnehin erzielbare hohe Druckqualität nochmals erhöht werden. In das Druckbild können bestimmte Informationen (z.B. das Guthaben einer neuwertigen Telefonkarte etc.) auch in Blindenschrift aufgenommen werden, z.B. durch Prägung bzw. durch besonders dicken Farbauftrag. Bei der fertiggestellten Karte können die außenliegenden Oberflächen der Deckschichten durch eine dünne Lackschicht, bestehend z.B. aus Nitrolack, Kalanderlack, UV-härtendem Lack, elektronenstrahlhärtendem Lack etc. geschützt sein. Der Lack kann in Form einer Glanzlackierung bzw. einer Mattlackierung aufgebracht werden. Ferner ist es möglich, die Lackschichten zu grainieren.

Einzelne Schichten können zusätzlich auch mit Sicherheitselementen, wie z.B. einem Wasserzeichen, Duftstoffen, Sicherheitsfäden, fluoreszierenden Fasern in Papier bzw. in Karten, Farbkapseln in Papierfasern, Hologrammen etc. versehen werden.

Auch das Aufbringen sonstiger Elemente, wie z.B. eine Magnetpiste durch das Auftragen eines Magnetlackes auf Wasserbasis oder einer Zündholzreibfläche, ist bei Papierkarten besonders einfach.

Schließlich können in die dickeren Papierschichten bzw. Kartonschichten bei der Herstellung dieser Schichten Fäden eingearbeitet werden, die diese Schichten schwieriger spaltbar machen. Entsprechende Techniken sind aus der Papierverarbeitung bekannt und sollen hier nicht näher erläutert werden. Zur Verbindung der einzelnen Papier- oder Kartonschichten können neben theromoaktivierbaren Klebern, auch Haftkleber oder Flüssigkleber eingesetzt werden. Um einem Aufspalten des Papiers oder Kartons im Bereich der Aussparung für das Modul vorzubeugen, können diese Bereiche durch Gewebe, Flüssigkleber oder Harze verfestigt werden.

## Patentansprüche

1. Ein- oder mehrschichtiger Datenträger, der als IC-Karte ausgebildet ist und ein eingebettetes elektronisches Modul (1) aufweist, das zum Austausch von Daten mit einem externen Gerät dient, wobei der Datenträger aus einem Kartenkörper (3) besteht, in den das elektronische Modul (1) eingebettet ist, **dadurch gekennzeichnet, dass** der Kartenkörper aus einem einschichtigen Karton besteht und das elektronische Modul für den berührungslosen Datenaustausch allseitig von Karton umgeben und in diesen formschlüssig eingebettet ist oder das elektronische Modul für die berührende Kontaktabnahme in einer zweistufigen Aussparung angeordnet ist, oder der Kartenkörper aus mehreren aus Papier oder Karton bestehenden Kern- und Deckschichten (3, 5, 7, 9) gebildet ist wobei das elektronische Modul für die berührende Kontaktabnahme in einer zweistufigen Aussparung angeordnet oder das Modul für die berührungslose Kontaktabnahme in einem Fenster der Kernschicht eingebettet ist.

2. Datenträger nach Anspruch 1, **dadurch gekennzeichnet, daß** die Abmessungen des Kartenkörpers (3) die ISO-Norm ISO 7810 erfüllen.

3. Datenträger nach den Ansprüchen 1 bis 2, **dadurch gekennzeichnet, daß** das eingebettete elektronische Modul (1) über Kontaktflächen (73) für eine berührende Kontaktaufnahme verfügt und daß die Kontaktflächen (73) in einem Bereich des Datenträgers liegen, der durch die ISO-Norm ISO 7816/2 festgelegt ist.

4. Datenträger nach einem oder mehreren der Ansprüche 1 bis 3, **dadurch gekennzeichnet**, zumindest die zwischen den Deckschichten (5, 9) des Kartenkörpers (3) liegenden Schichten (7, 21, 23) mit Fenstern (15) zur Aufnahme des elektronischen Moduls (1) versehen sind.

5. Datenträger nach Anspruch 4, **dadurch gekennzeichnet, daß** die Schichten (5, 7, 9) durch Klebeschichten (11, 21, 23) miteinander verbunden sind, die entweder als thermoaktivierbare Schichten oder als Haftkleberschichten ausgebildet sind.

6. Datenträger nach den Ansprüchen 4 und 5, **dadurch gekennzeichnet, daß** zumindest eine der Deckschichten (5, 9) mit einem Fenster (13) versehen ist, so daß im Kartenkörper (3) zusammen mit den Fenstern (15) der Mittelschichten (7, 21, 23) eine zweistufige Aussparung gebildet wird, in die ein elektronisches Modul (1) für die berührende Kontaktabnahme eingebettet wird.

7. Datenträger nach einem der Ansprüche 1 bis 6, **dadurch gekennzeichnet, daß** das elektronische Modul (1) mit einem Flüssigkleber (59) in die Aussparung eingeklebt ist.

8. Datenträger nach Anspruch 7, **dadurch gekennzeichnet, daß** der Flüssigkleber (59) zumindest weitgehend den gesamten Wandbereich der Aussparung benetzt, so daß einem Aufspalten der Kartenschichten in diesem Bereich vorgebeugt ist.

9. Datenträger nach einem der Ansprüche 7 oder 8, **dadurch gekennzeichnet, daß** die Aussparung mit mindestens einer Hinterschneidung (63) versehen ist, die mit Flüssigkleber (59) gefüllt ist.

10. Verfahren zu herstellung eines Datenträgers, einer IC-Karte nach Anspruch 1, **dadurch gekennzeichnet, daß**
- von einer Rolle in Endlosform ein Karton (17) in der Stärke des Datenträgers bereitgestellt wird,
- in vorgegebenen Abständen der Karton (17) mit Stanzungen versehen wird, so daß in dem Karton (17) Fenster (15) entstehen,
- im Bereich der Fenster (15) der Karton (17) mit einer Tiefprägung versehen wird, so daß im Bereich der Fenster (15) in dem Karton (17) vertiefungen (19) mit einem größeren Durchmesser als dem der Fenster (15) entstehen,
- in den derart entstandenen Aussparungen des Kartons (17) elektronische Module (1) eingesetzt werden, wobei ein erster Bereich des Moduls (1), der Kontaktflächen (73) für eine berührende Kontaktierung trägt, in der Vertiefung (19) und .ein zweiter Bereich des Moduls (1), der einen integrierten Schaltkreis tragt, in dem Fenster (15) liegt,
- die Module in den Aussparungen verklebt werden.
- einzelne Datenträger aus der Rolle ausgestanzt werden.

11. Verfahren zur Herstellung eines Datenträgers nach Anspruch 1, **dadurch gekennzeichnet, daß**
- jeweils von einer Rolle eine obere (5), eine untere Deckschicht (9) und mindestens eine Kernschicht (7) aus Karton und/oder Papier bereitgestellt werden,
- in der Kernschicht (7) in vorbestimmten Abständen Fenster (15) eingestanzt werden,
- die Kernschicht (7) und die untere Deckschicht (9) zusammengeführt und verklebt werden, wobei an den Positionen der Fenster (15) in der Kernschicht (7) Aussparungen entstehen,
- in die entstehenden Aussparungen ein elektronisches Modul (1) für die berührungslose Kontaktabnahme eingebracht wird,
- die Kernschicht (7) mit der oberen Deckschicht (5) zusammengeführt und verklebt wird und
- aus dem entstandenen Band einzelne Datenträger ausgestanzt werden.

12. Verfahren zur Herstellung eines Datenträgers nach Anspruch 1, **dadurch gekennzeichnet, daß**
- jeweils von einer Rolle eine obere (5), eine untere Deckschicht (9) und mindestens eine Kernschicht (7) aus Karton und/oder Papier bereitgestellt wird,
- die Kernschicht (7) und die obere Deckschicht (5) durch Stanzungen mit Fenstern (13,15) versehen werden, wobei die Öffnungen in der Deckschicht (5) größer sind als die Öffnungen in der Kernschicht (7),
- die drei Schichten (5, 7, 9) miteinander verbunden werden, so daß ein Band entsteht, das in vorbestimmten Abständen über zweistufige Aussparungen verfügt.
- in die zweistufigen Aussparungen elektronische Module (1) eingebracht werden, wobei ein Teil des elektronischen Moduls (1), der Kontaktflächen (73) für eine berührende Kontaktabnahme trägt, in dem oberen Bereich der Aussparung liegt und ein Teil des elektronischen Moduls (1), der einen integrierten Schaltkreis aufnimmt, in dem unteren Bereich der Aussparung liegt,
- aus dem entstandenen Band einzelne Datenträger ausgestanzt werden.

13. Verfahren zur Herstellung eines Datenträgers nach Anspruch 1, **dadurch gekennzeichnet, daß**
- jeweils von einer Rolle eine obere (5), eine untere (9) und mindestens eine Kernschicht (7) aus Karton und/oder Papier bereitgestellt werden,
- die Schichten miteinander verbunden werden; so daß ein Band bzw. Bogen entsteht,
- in vorbestimmten Abständen mit einem Schneidwerkzeug (41) zumindest in die obere Deckschicht (5) derart eingeschnitten wird, daß die Schnittkante (43) einen Bereich umfaßt,
- mit einem Fräswerkzeug in dem genannten Bereich eine Aussparung erzeugt wird, wobei die in der oberen Deckschicht (5) liegende Begrenzung der Aussparung durch die Schnittkante (43) festgelegt wird,
- in die entstandenen Aussparungen elektronische Module (1) eingebracht werden,
- aus dem entstandenen Band bzw. Bogen einzeine Datenträger ausgestanzt werden.

14. Verfahren zur Herstellung eines Datenträgers nach Anspruch 1, **dadurch gekennzeichnet, daß** ein Karton (17) hergestellt wird, der die Kartendicke aufweist und daß bereits bei der Herstellung des Kartons das elektronische Modul (1) für den berührungslosen Datenaustausch in den Karton (17) eingebettet wird, so daß das Modul (1) allseitig und formschlüssig von dem Karton (17) umgeben ist.

15. Verfahren nach Anspruch 12, **dadurch gekennzeichnet, daß** die Module (1) vor dem Verbinden der einzelnen Schichten in den Kartenaufbau eingelegt werden und beim Verbinden der Schichten direkt in den entstehenden Aussparungen verklebt werden.

## Claims

1. A one- or multilayer data carrier designed as an IC card and having an embedded electronic module (1) to be used for exchanging data with an external device, the data carrier consisting of a card body (3) in which the electronic module (1) is embedded, **characterized in that** the card body is formed from a single-layer cardboard and the electronic module is surrounded by cardboard on all sides and embedded positively therein for noncontacting data exchange, or the electronic module is disposed in a two-step gap for touch contacting, or the card body is formed from a plurality of core and cover layers (3, 5, 7, 9) consisting of paper or cardboard, the electronic module being disposed in a two-step gap for touch contacting or the module being embedded in a window of the core layer for noncontacting communication.

2. The data carrier according to claim 1, **characterized in that** the dimensions of the card body (3) fulfill the ISO standard ISO 7810.

3. The data carrier according to claims 1 to 2, **characterized in that** the embedded electronic module (1) has contact surfaces (73) for touch contact, and the contact surfaces (73) are located in an area of the data carrier fixed by the ISO standard ISO 7816/2.

4. The data carrier according to one or more of claims 1 to 3, **characterized in that** at least the layers (7, 21, 23) located between the cover layers (5, 9) of the card body (3) are provided with windows (15) for receiving the electronic module (1).

5. The data carrier according to claim 4, **characterized in that** the layers (5, 7, 9) are interconnected by adhesive layers (11, 21, 23) formed either as thermally activable layers or as contact adhesive layers.

6. The data carrier according to claims 4 and 5, **characterized in that** at least one of the cover layers (5, 9) is provided with a window (13) so that a two-step gap in which an electronic module (1) is embedded for contacting communication is formed in the card body (3) along with the windows (15) in the middle layers (7, 21, 23).

7. The data carrier according to any of claims 1 to 6, **characterized in that** the electronic module (1) is glued into the gap with a liquid adhesive (59).

8. The data carrier according to claim 7, **characterized in that** the liquid adhesive (59) moistens at least largely the entire wall area of the gap so as to prevent splitting of the card layers in this area.

9. The data carrier according to either of claims 7 and 8, **characterized in that** the gap is provided with at least one undercut (63) filled with liquid adhesive (59).

10. A method for producing a data carrier, an IC card according to claim 1, **characterized by** the steps of
- supplying cardboard (17) with the thickness of the data carrier from a roll in endless form,
- providing the cardboard (17) with punchings at predetermined intervals so that windows (15) arise in the cardboard (17),
- providing the cardboard (17) with debossing in the area of the windows (15) so that depressions (19) with a greater diameter than that of the windows (15) arise in the cardboard (17) in the area of the windows (15),
- inserting electronic modules (1) in the resulting gaps in the cardboard (17), whereby a first area of the module (1) bearing contact surfaces (73) for contacting coupling is located in the depression (19) and a second area of the module (1) bearing an integrated circuit is located in the window (15),
- gluing the modules in the gaps,
- punching individual data carriers out of the roll.

11. A method for producing a data carrier according to claim 1, **characterized by** the steps of
- supplying an upper cover layer (5), a lower cover layer (9) and at least one core layer (7) of cardboard and/or paper each from a roll,
- punching windows (15) in the core layer (7) at predetermined intervals,
- bringing the core layer (7) and the lower cover layer (9) together and gluing them, whereby gaps arise in the core layer (7) at the positions of the windows (15),
- introducing an electronic module (1) for noncontacting communication in the resulting gaps,
- bringing the core layer (7) together with the upper cover layer (5) and gluing them, and
- punching individual data carriers out of the resulting band.

12. A method for producing a data carrier according to claim 1, **characterized by** the steps of
- supplying an upper cover layer (5), a lower cover layer (9) and at least one core layer (7) of cardboard and/or paper each from a roll,
- providing the core layer (7) and the upper cover layer (5) with windows (13, 15) by punching, the openings in the cover layer (5) being greater than the openings in the core layer (7),
- interconnecting the three layers (5, 7, 9), yielding a band having two-step gaps at predetermined intervals,
- introducing electronic modules (1) in the two-step gaps, whereby a part of the electronic module (1) bearing contact surfaces (73) for contacting communication is located in the upper area of the gap and a part of the electronic module (1) receiving an integrated circuit is located in the lower area of the gap,
- punching individual data carriers out of the resulting band.

13. A method for producing a data carrier according to claim 1, **characterized by** the steps of
- supplying an upper layer (5), a lower layer (9) and at least one core layer (7) of cardboard and/or paper each from a roll,
- interconnecting the layers, yielding a band or sheet,
- cutting in at least the upper cover layer (5) with a cutting tool (41) at predetermined intervals in such a way that the edge of cut (43) includes a certain area,
- using a milling tool to produce a gap in said area, whereby the limit of the gap located in the upper cover layer (5) is fixed by the edge of cut (43),
- introducing electronic modules (1) in the resulting gaps,
- punching individual data carriers out of the resulting band or sheet.

14. A method for producing a data carrier according to claim 1, **characterized in that** a cardboard (17) having the card thickness is produced, and the electronic module (1) is already embedded in the cardboard (17) during production of the cardboard for contactless data exchange, so that the module (1) is surrounded by the cardboard (17) on all sides and positively.

15. The method according to claim 12, **characterized in that** the modules (1) are inserted in the card structure before connection of the individual layers, and are glued directly in the resulting gaps during connection of the layers.

## Revendications

1. Support de données à une ou plusieurs couches, réalisé sous la forme d'une carte à circuit intégré et qui comporte un module électronique (1) encastré ou noyé, qui sert à l'échange de données avec un appareil extérieur, dans lequel le support de données est composé d'un corps de carte (3) dans lequel est encastré ou noyé le module électronique (1), **caractérisé en ce que** le corps de carte est composé de carton à une couche et le module électronique, pour échange de données sans contact est entouré de tous les côtés par du carton et est encastrés à correspondance de forme dans celui-ci, ou le module électronique, pour échange de données avec contact est disposé dans un évidement bi-étagé, ou le corps de carte est composé de plusieurs couches de coeur et de recouvrement (3, 5 7, 9) dans lequel le module électronique pour échange de données avec contact est disposé dans un évidement bi-étagé, ou le module pour échange de données sans contact est encastré dans une fenêtre de la couche de coeur.

2. Support de données selon la revendication 1, **caractérisé en ce que** les dimensions du corps de carte (3) satisfont à la norme ISO 7810.

3. Support de données selon les revendications 1 à 2, **caractérisé en ce que** le module électronique (1) encastré ou noyé est disposé par l'intermédiaire de surfaces de contact (73) pour réaliser une réception de contact du type avec contact, et **en ce que** les surfaces de contact (73) sont disposées dans une zone du support de données qui est fixée par la norme ISO 7816/2.

4. Support de données selon l'une ou plusieurs des revendications 1 à 3, **caractérisé en ce qu'**au moins les couches (7, 21, 23) situées entre les couches de recouvrement (5, 9) du corps de carte (3) sont munies de fenêtres (15) pour recevoir le module électronique (1).

5. Support de données selon la revendication 4, **caractérisé en ce que** les couches (5, 7, 9) sont reliées les unes aux autres par des couches collantes ou adhésives (11, 21, 23) qui sont constituées, soit de couches thermoadhésives, soit de couches collées par adhérence.

6. Support de données selon les revendications 4 et 5, **caractérisé en ce qu'**au moins l'une des couches de recouvrement (5, 9) est munie d'une fenêtre (13), de telle façon qu'il se forme dans le corps de carte (3), en coopération avec les fenêtres (15) des couches médianes (7, 21, 23), un évidement bi-étagé, dans lequel est noyé un module électronique (1) pour réaliser une réception de contact établissant un contact.

7. Support de données selon l'une des revendications 1 à 6, **caractérisé en ce que** le module électronique (1) est collé dans l'évidement par un adhésif ou une colle liquide (59).

8. Support de données selon la revendication 7, **caractérisé en ce que** l'adhésif ou la colle liquide (59) mouille au moins largement la totalité de la zone de paroi de l'évidement, de telle sorte qu'il empêche une séparation des couches de la carte dans cette zone.

9. Support de données selon l'une des revendications 7 ou 8, **caractérisé en ce que** l'évidement est muni d'au moins une découpe en contre-dépouille (63), qui est remplie d'adhésif ou la colle liquide (59).

10. Procédé de fabrication d'un support de données, à savoir une carte à circuit intégré selon la revendication 1, **caractérisé en ce que**:
- on prépare, à partir d'un rouleau en forme de bande continue, un carton (17) présentant l'épaisseur principale du support de donnée,
- à des distances prédéterminées, on munit le carton (17) de découpes poinçonnées, de telle façon qu'il se forme dans le carton (17) des fenêtres (15),
- dans la zone de la fenêtre (15) du carton (17), on forme une découpe profonde, de telle façon que dans la zone de la fenêtre (15) apparaissent dans le carton (17) des évidements (19) présentant un plus grand diamètre que celui de la fenêtre (15),
- dans les évidements ainsi créés du carton (17), on introduit des modules électroniques (1), une première zone du module (1) qui porte des surfaces de contact (73) pour un contact avec contact physique, étant disposée dans l'évidement (19) et une deuxième zone du module (1) qui porte un circuit intégré, étant disposée dans la fenêtre (15),
- on colle les modules dans les évidements,
- on découpe par poinçonnage les supports de données individuels pour les séparer du rouleau.

11. Procédé de fabrication d'un support de données selon la revendication 1, **caractérisé en ce que**:
- on prépare chaque fois, à partir d'un rouleau, une couche de recouvrement supérieure (5), inférieure (9) et au moins une couche de coeur (7) en carton et/ou en papier,
- dans la couche de coeur (7), on découpe à des distances prédéterminées des fenêtres (15),
- on ajuste et on colle ensemble la couche de coeur (7) et la couche de recouvrement inférieure (9), de telle façon qu'aux positions des fenêtres (15) dans la couche de coeur (7), apparaissent des évidements,
- dans les évidements ainsi formés, on introduit un module électronique (1) du type à communication sans contact,
- on ajuste et on colle ensemble la couche de coeur (7) à la couche de recouvrement supérieure (5), et
- on découpe les supports de données individuels pour les séparer de la bande existante.

12. Procédé de fabrication d'un support de données selon la revendication 1, **caractérisé en ce que**:
- on prépare chaque fois à partir d'un rouleau une couche de recouvrement supérieure (5) et inférieure (9) et au moins une couche de coeur (7) en carton et/ou en papier,
- on munit, par des découpes poinçonnées, la couche de coeur (7) et la couche de recouvrement supérieure (5) de fenêtres (13, 15), les ouvertures dans la couche de recouvrement (5) étant plus grandes que les ouvertures dans la couche de coeur (7),
- on relie les trois couches (5, 7, 9) les unes aux autres, de façon à former une bande qui, à des distances prédéterminées, présente des évidements biétagés,
- dans les évidements biétagés, on place des modules électroniques (1), une partie du module électronique (1) qui porte les surfaces de contact (73) pour une réception de contact du type à contact physique, étant disposée dans la zone supérieure de l'évidement et une partie du module électronique (1) qui comporte un circuit intégré, étant disposée dans la zone inférieure de l'évidement,
- à partir de la bande ainsi formée, on découpe par poinçonnage des supports de données individuels.

13. Procédé de fabrication d'un support de données selon la revendication 1, **caractérisé en ce que**:
- on prépare chaque fois à partir d'un rouleau une couche supérieure (5), une couche inférieure (9) et au moins une couche de coeur (7) en carton et/ou en papier,
- on relie les couches les unes aux autres, de façon à former une bande ou une partie arquée,
- à des distances prédéterminées, avec un outil à découper (41) on procède à une découpe au moins dans la couche de recouvrement supérieure (5), de telle façon que l'arête de découpe (43) entoure une zone,
- avec une fraise, dans la zone citée, on crée un évidement, la délimitation de l'évidement situé dans la couche de recouvrement supérieure (5) étant déterminée par l'arête de découpe (43),
- dans les évidements créés, on dispose des modules électroniques (1),
- à partir de la bande ou de l'arc ainsi créés, on découpe par poinçonnage des supports de données individuels.

14. Procédé de fabrication d'un support de données selon la revendication 1, **caractérisé en qu'**on fabrique un carton (17) qui présente l'épaisseur de la carte et en ce que, déjà au cours de la fabrication du carton, on encastre le module électronique (1) pour l'échange de données sans contact, de sorte que le module soit entouré sur toutes les côtés et avec ajustement de forme par le carton (17).

15. Procédé selon la revendication 12, **caractérisé en ce que**, avant la liaison des couches individuelles, les modules (1) sont déposés dans la structure de la carte et, à la liaison des couches, sont collés directement dans les évidements qui en résultent.
